# FASCICULE DE BREVET EUROPEEN

(11) **EP 1 325 886 B1**
(45) Date de publication et mention de la délivrance du brevet: **29.09.2004**
(21) Numéro de dépôt: 02293119.0
(22) Date de dépôt: 17.12.2002
(51) Int. Cl.: B81B 7/00, B81C 1/00

(54) **Procédé de renforcement d'une microstructure mécanique**
Verfahren zum Verstärken einer mechanischen Mikrostruktur
Method of reinforcing a mechanical microstructure

(30) Priorité: 28.12.2001 FR 0117014
(43) Date de publication de la demande: 09.07.2003
(73) Titulaire: COMMISSARIAT A L'ENERGIE ATOMIQUE, 75752 Paris Cédex 15 (FR)
(72) Inventeur: Caplet, Stéphane, 38360 Sassenage (FR)
(74) Mandataire: Santarelli

(56) Documents cités:
- WO-A-95/17014
- WO-A-95/33282
- FR-A- 2 785 449
- US-B1- 6 225 145
- CHAVAN A V ET AL: "A monolithic fully-integrated vacuum-sealed CMOS pressure sensor" PROCEEDINGS IEEE THIRTEENTH ANNUAL INTERNATIONAL CONFERENCE ON MICRO ELECTRO MECHANICAL SYSTEMS (CAT. NO.00CH36308), PROCEEDINGS IEEE THIRTEENTH ANNUAL INTERNATIONAL CONFERENCE ON MICRO ELECTRO MECHANICAL SYSTEMS, MIYAZAKI, JAPAN, 23-27 JAN. 2000, pages 341-346, XP010377150 2000, Piscataway, NJ, USA, IEEE, USA ISBN: 0-7803-5273-4

## Description

La présente invention concerne un procédé de réalisation d'une microstructure mécanique et une microstructure mécanique comportant une partie électriquement active. Une telle microstructure peut avantageusement constituer un élément capteur, par exemple de pression, ou un actionneur tel qu'un micro système optique (MOEMS). Elle trouve une application privilégiée, mais non exclusive, dans le domaine des composants inertiels, tels que des accéléromètres.

On connaît, notamment par le document FR 2.558.263 de la Demanderesse, la fabrication de dispositifs micromécaniques par les techniques de la micro électronique. Ces procédés permettent de réaliser une microstructure, que l'on définira comme étant une structure mécanique réalisée avec les techniques de la micro électronique, à savoir, traitement collectif de substrats par dépôt, gravure, photolithographie, etc...

Dans le cas des accéléromètres, la partie électriquement active peut être en partie portée une pièce mobile, la mesure de l'accélération s'effectuant alors par exemple en mesurant une variation de la capacité électrique entre cette pièce mobile et une partie fixe de la microstructure mécanique.

De façon connue, notamment par le document FR-2.770.339 de la Demanderesse, une telle microstructure peut comporter un capot de confinement de la partie active.

Au cour de leur développement, les inventeurs ont tout d'abord été confrontés au problème de la formation de capacités parasites entre la partie active et le capot. Il y a lieu en effet de diminuer celles-ci, notamment lorsque l'on souhaite réaliser un capteur de grande sensibilité.

Dans ce but, et selon une première caractéristique de l'invention, ils ont ménagé un retrait dans le capot, à l'aplomb et à distance prédéterminée de la partie active.

Cette distance prédéterminée est en particulier suffisamment importante pour limiter, voire éviter l'apparition de la capacité parasite précitée.

Par ailleurs, et comme explicité dans le document FR 2.770.339, la partie électriquement active peut-être réalisée dans une couche formée sur un substrat, le substrat comportant au moins un trou débouchant sur une face interne de cette couche, au travers duquel on forme un contact électrique avec la partie électriquement active sur la face interne de cette couche.

Ce contact électrique peut être réalisé sur un dépôt métallique, en utilisant par exemple une technique de soudure à ultrasons connue de l'homme du métier.

Le document WO 95/33282 montre un procédé de fabrication d'un accéléromètre où la masse mobile est soudée au substrat par l'intermédiaire de butées d'oxyde PSG, et est contactée avec un fil par l'arrière.

Les inventeurs se sont trouvés confrontés aux problèmes liés à la faible épaisseur de la couche dans laquelle la partie active est réalisée, par exemple 60 µm, et plus particulièrement à sa grande fragilité.

Ils ont en effet constatés au cours de leurs recherches, qu'une dégradation pouvait apparaître, notamment au moment de la réalisation du contact électrique sur la face interne de la couche, les vibrations ultrasoniques alliées à la pression du dispositif de soudure étant susceptibles d'entraîner la rupture de la couche mince, cela à raison de sa grande fragilité, lorsque la face externe de cette couche est en regard de la cavité.

Ils ont d'ailleurs relevé que l'agencement d'une trop grande distance prédéterminée, selon la première caractéristique susvisée de l'invention, était susceptible de favoriser cette rupture, un compromis étant difficile, voire impossible, à trouver entre la minimisation des capacités parasites et l'absence de rupture.

Pour résoudre ce problème, la présente invention vise un procédé de réalisation d'une microstructure mécanique comportant une première couche déformable située en porte-à-faux vis-à-vis d'une deuxième couche comportant une cavité aménagée en retrait d'une face externe de la première couche déformable, procédé selon lequel on connecte un fil à une portion d'une face interne de la première couche déformable.

Selon l'invention, la portion est en regard d'une zone de fond de la cavité dans la cavité dans laquelle un plot de butée vient en saillie, tout en étant à distance de la première couche déformable.

Grâce à ces dispositions l'invention pallie les inconvénients susvisés. En effet :
- d'une part, grâce au caractère localisé du plot de butée, le retrait aménagé à l'aplomb de la première couche est à une distance prédéterminée suffisante pour empêcher la formation de capacités parasites entre la première couche et la deuxième couche ; et
- d'autre part, à l'aplomb de la portion de connexion, la distance entre la première couche et la deuxième couche étant diminuée, sans être nulle, le plot de butée limite la déformation de la première couche mince lors de l'opération de soudure, ce qui permet d'éviter toute détérioration locale de cette couche.

Selon une première caractéristique, la microstructure comportant en outre une couche support de la première couche, au cours du procédé selon l'invention, on aménage un puits dans le support débouchant en regard de la portion de la face interne de la première couche et on réalise la connexion du fil à la première couche à travers le puits.

Selon une autre caractéristique, après l'étage d'aménagement du puits, on dépose une couche localisée de contact du fond du puits, la liaison entre le fil de connexion et la première couche étant réalisée au moyen de la couche de contact.

La connexion peut ainsi être obtenue par la technique dite du Ball Bonding.

Corrélativement, la présente invention vise également une microstructure mécanique comportant une première couche déformable située en porte-à-faux vis-à-vis d'une deuxième couche comportant une cavité aménagée en retrait d'une face externe de la première couche déformable, la première couche comportant une portion à laquelle est connectée un fil.

Selon l'invention, cette portion est en regard d'une zone de fond de la cavité dans laquelle un plot de butée vient en saillie tout en étant à distance de la première couche déformable.

Les caractéristiques et avantages de ladite microstructure mécanique identiques à ceux du procédé de réalisation selon l'invention, ne seront pas rappelés ici.

Selon une caractéristique particulière, la microstructure comporte une couche isolante entre la première couche isolante et la couche support, cette couche isolante comportant un retrait sous les bords du puits.

Cette caractéristique est particulièrement avantageuse, car elle garantit qu'il y a discontinuité électrique entre un éventuel dépôt sur une paroi du puits et la couche localisée du contact.

D'autres aspects et avantages de la présente invention apparaîtront plus clairement à la lecture de la description de modes particuliers de réalisation qui va suivre, cette description étant donnée uniquement à titre d'exemple non limitatif et faite en référence aux dessins annexés sur lesquels :-
- la figure 1 représente une microstructure du type géophone en voie d'achèvement ;
- la figure 2 en est une vue de dessous de l'ensemble de la figure 1 dans une variante de réalisation,
- la figure 3 est une vue de dessus du second substrat après libération d'une partie sensible,
- la figure 4 est une vue agrandie de l'ensemble de la figure 1, après retournement pour la fixation d'une liaison électrique, et
- la figure 5 est une vue schématique générale d'un substrat supportant une couche mince sur laquelle une connexion électrique est réalisée en une zone en porte-à-faux.

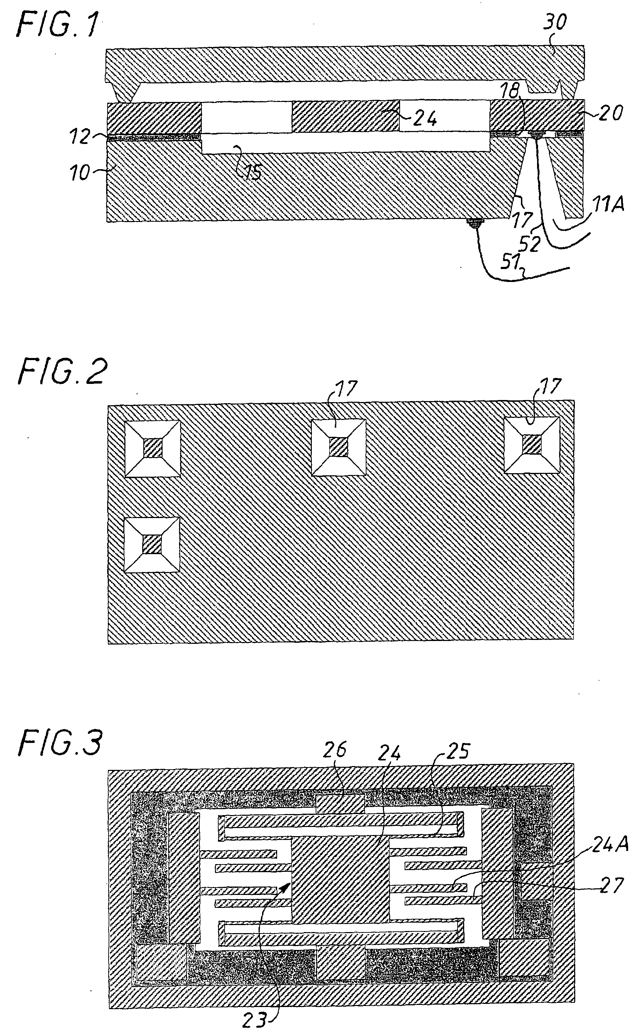

La **figure 1** représente une microstructure du type géophone en voie d'achèvement, comportant au moins trois parties principales, une partie centrale 20 comportant une masse mobile 24 sensible aux accélérations à détecter par le géophone, une partie support 10 qui porte cette partie centrale, et une partie supérieure 30 qui recouvre cette partie centrale et qui définit avec la partie support 10 une enceinte dans laquelle il est possible, le cas échéant, de faire le vide.

Dans un mode préféré de réalisation, chacune de ces parties est réalisée à partir d'un substrat en Silicium.

En variante, l'un au moins de ces substrats est en un matériau différent.

Chacun de ces substrats peut avoir au départ les mêmes caractéristiques, notamment la même épaisseur, par exemple 450 µm.

Dans un mode préféré de réalisation, le substrat 30 correspondant à la partie supérieure à une épaisseur de 300 µm.

Toutefois, puisque, dans le cas d'un géophone, la partie centrale doit en principe avoir finalement une épaisseur bien plus faible (on parle d'une couche mince) il faut, préalablement aux étapes spécifiques de réalisation de la microstructure voulue, réduire l'épaisseur du substrat 20 jusqu'à l'obtention d'une couche d'épaisseur par exemple égale à quelques dizaines de microns.

Dans un mode préféré de réalisation, l'épaisseur finale de la couche mince 20 est de l'ordre de 60 microns.

Cette couche mince peut être obtenue par tout moyen connu approprié, par exemple par attaque de la partie excédentaire du susbtrat.

Nous allons maintenant décrire brièvement l'obtention d'une telle microstructure.

Dans un premier temps, la partie support 10 est revêtue d'une couche 12 d'oxyde discontinue, cette couche d'oxyde étant appliquée sur les parties de la face de la partie support 10 destinées à être scellées à la couche mince 20.

De préférence cette couche d'oxyde 12 est constitué du matériau dans lequel le substrat 10 est constitué, à savoir de l'oxyde de silicium.

La couche mince 20 est ensuite rapportée sur le substrat 10 dans lequel une cavité 15 a été réalisée, par exemple par gravure à travers un masque non représenté.

De manière préférée, la couche mince est reportée sur le substrat 10 par la technique du collage moléculaire Si/SiO₂ sous vide. La couche d'oxyde 12 sert ici d'isolant entre la couche mince et le substrat 10. Selon cette technique de collage, un recuit ultérieur à haute température, par exemple à 1100°C (voir plus loin), permet un renforcement du scellement.

Après les opérations de collage et recuit, on amincit le substrat 20 par usinage mécano-chimique et/ou par attaque chimique afin d'obtenir une couche 20 d'épaisseur désirée.

On procède à un traitement de gravure du substrat 10 sur toute son épaisseur à l'endroit d'une ouverture 11A en sorte de former un puits 17 destiné à une reprise de contact électrique.

Ce traitement est ici une gravure anisotrope au KOH, ce qui se traduit par une section du puits 17 qui diminue vers le haut, c'est à dire vers la couche mince 20.

Cette attaque est poursuivie jusqu'au travers de la couche d'oxyde 12, en pratique par une technique de gravure chimique (avec de l'acide fluorhydrique HF par exemple), ce qui permet d'obtenir un retrait 18 de la couche d'oxyde 12 sous les bords du puits 17, et donc un surplomb de ceux-ci vis-à-vis de la couche mince.

Ainsi que cela ressort de la **figure 2**, il y a avantageusement plusieurs puits 17 de contact, nombre défini en fonction du nombre de connexions à établir avec la couche mince (il y a donc eu un nombre égal d'ouvertures). Dans l'exemple considéré ici, les puits sont identiques, et ont une section carrée.

Selon un masque non représenté, il y a ensuite découpe dans la couche mince 20 d'une partie sensible 23, classiquement appelée "structure", par exemple par gravure sèche (de type DRIE, "Deep Reactive Dry Etching", notamment) en sorte de détourer mécaniquement et électriquement cette structure qui se trouve libérée, en fin de gravure, vis-à-vis du reste de la couche mince et du reste de l'ensemble.

Ainsi que cela est représenté à la **figure 3,** la structure obtenue dans l'exemple considéré ici comporte une partie centrale 24 reliée aux bords de la cavité par des poutres sustentatrices 25 qui font office de ressort de rappel, ces poutres étant reliées à deux plots d'ancrage 26.

De cette masse centrale sont solidaires des poutres en porte-à-faux 24A disposées auprès de poutres en porte-à-faux 27 fixes : par effet capacitif ces poutres en porte-à-faux permettent de mesurer l'amplitude du mouvement de la partie centrale en réponse à une accélération. . Pour plus de précisions, le lecteur pourra se reporter au document FR 2558263 cité dans le préambule de cette demande de brevet.

Le troisième substrat 30 réalisant capot est ensuite positionné sur la couche mince 20 elle même positionnée sur le support 10.

Le scellement de ce capot 30 avec l'ensemble constitué de la couche mince 20 et du support 10 peut par exemple être réalisé par une technique connue de scellement eutectique qui ne sera pas décrite ici.

Après la solidarisation des trois éléments 10, 20 et 30 de la figure 1, des aménagements sont réalisés pour permettre de relier la partie active à l'extérieur.

La figure 1 montre ainsi cet ensemble après fixation de fils de connexion 51 et 52, dont l'un est connecté à la surface extérieure du substrat 10, et l'autre est fixé au fond d'un puits 17.

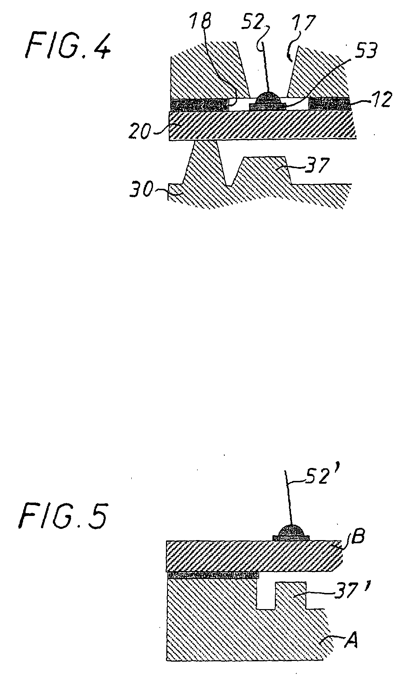

Ainsi que cela ressort de la **figure 4**, cette connexion au fond du puits 17 se fait avantageusement après dépôt d'une couche localisée de contact 53.

Cette couche peut notamment être obtenue en utilisant les parois du puits comme masque, auquel cas la couche localisée de contact a la section de la partie basse de ce puits sur cette figure.

L'existence d'un dépôt sur les parois de ce puits n'est pas gênante dans la mesure où le retrait 18 de la couche d'oxyde 12 garantit qu'il y a discontinuité entre un éventuel dépôt sur cette paroi et la couche localisée.

Les contacts électriques sont en pratique réalisés sur la couche mince en une zone disposée à l'extérieur de l'ouverture dans laquelle la partie centrale est mobile.

Toutefois, cette couche mince, encastrée mais en porte-à-faux à l'endroit considéré, peut ne pas avoir une rigidité suffisante pour résister aux efforts de poussée qu'impliquent la soudure d'un fil à la couche localisée. Dans la configuration de la figure 4 ces efforts de poussée sont dirigés vers le bas.

C'est notamment pour éviter que ces efforts de poussée ne risquent de dégrader la couche mince 20 qu'un plot 37 est prévu, dans le troisième substrat 30 réalisant capot, en regard de chaque zone de la couche mince où doit se faire une soudure.

Ce plot 37 constitue ainsi une butée qui limite la déformation de la couche mince lors de cette opération de soudure à un niveau n'impliquant aucune dégradation de celle-ci. L'opération de soudure peut donc être effectuée en toute sécurité (il s'agit par exemple d'une opération selon la technologie dite "Ball-Bonding").

Le principe général de cette connexion est représenté à la **figure 5** : la liaison d'un fil de connexion 52' à une portion de couche déformable B qui est en porte-à-faux vis-à-vis d'un support A comportant une cavité, est avantageusement réalisée en regard d'une zone de fond de cette cavité dans laquelle un plot de butée 37' vient en saillie tout en étant à distance de cette couche.

Le retrait de la butée 37 ou 37' par rapport à la couche mince est avantageusement ici de l'ordre de quelques microns (il dépend de la distance à l'encastrement).

Ce qui précède s'applique à des géophones ainsi qu'à divers autres systèmes ou micro-structures où il y a besoin de connecter une couche mince en porte à faux sur un substrat.

La connexion aux plots de contact est avantageusement réalisée à la faveur de puits et de plots de butée décrits ci-dessus.

## Revendications

1. Procédé de réalisation d'une microstructure mécanique comportant une première couche déformable (20) située en porte à faux vis-à-vis d'un deuxième couche (30) comportant une cavité aménagée en retrait d'une face externe de ladite première couche déformable (20) selon lequel on connecte un fil (52) à une portion (B) d'une face interne de ladite première couche déformable (20), ladite portion (B) étant en regard d'une zone de fond de ladite cavité dans laquelle un plot de butée (37) vient en saillie, **caractérisé en ce que** ledit plot de butée (37) est à distance de ladite première couche déformable (20).

2. Procédé de réalisation d'une microstructure selon la revendication 1, ladite microstructure comportant en outre une couche support (10) de ladite première couche (20), **caractérisé en ce que** :
- on aménage un puits (17) dans ledit support (10) débouchant en regard de ladite portion (B) de la face interne de la première couche (20) ; et
- on réalise ladite connexion dudit fil (52) à ladite face interne de la première couche (20) à travers ledit puits (17).

3. Procédé de réalisation d'une microstructure selon la revendication 2, **caractérisé en ce que**, après ladite étape d'aménagement, on dépose une couche localisée de contact (53) au fond dudit puits (17), ladite liaison entre le fil de connexion (52) et ladite première couche (20) étant réalisée au moyen de ladite couche de contact (53).

4. Microstructure mécanique comportant une première couche déformable (20) située en porte à faux vis-à-vis d'une deuxième couche (30) comportant une cavité aménagée en retrait d'une face externe de ladite première couche déformable (20), la première couche (20) comportant une portion (B) à laquelle est connectée un fil (52), ladite portion (B) étant en regard d'une zone de fond de ladite cavité dans laquelle un plot de butée (37) vient en saillie, **caractérisé en ce que** ledit plot de butée (37) est à distance de ladite première couche déformable (20).

5. Microstructure mécanique selon la revendication 4 comportant en outre une couche support (10) de ladite première couche (20), **caractérisée en ce que** ledit support (10) comporte un puits (17) débouchant en regard de ladite portion (B) de la face interne de ladite première couche (20).

6. Microstructure selon la revendication 5, **caractérisée en ce qu'**elle comporte une couche localisée de contact (53) au fond dudit puits (17), ladite liaison entre le fil de connexion (52) et ladite première couche (20) étant réalisée au moyen de ladite couche de contact (53).

7. Microstructure selon l'une quelconque des revendications 5 ou 6, ladite microstructure comportant une couche isolante (12) entre ladite première couche (20) et ladite couche support (10), **caractérisée en ce que** ladite couche isolante (12) comporte un retrait (18) sous les bords dudit puits (17).

## Patentansprüche

1. Verfahren zur Herstellung einer mechanischen Mikrostruktur, die eine erste verformbare Schicht (20) umfasst, die sich auskragend gegenüber einer zweiten Schicht (30) befindet, die einen Hohlraum aufweist, der zurückspringend von einer äußeren Fläche der ersten verformbaren Schicht (20) ausgebildet ist, wobei in dem Verfahren ein Draht (52) mit einem Abschnitt (B) einer inneren Fläche der ersten verformbaren Schicht (20) verbunden wird, wobei sich der Abschnitt (B) gegenüber einer Bodenzone des Hohlraums befindet, in der ein Anschlaghöcker (37) vorsteht, **dadurch gekennzeichnet, dass** sich der Anschlaghöcker (37) in einem Abstand von der ersten verformbaren Schicht (20) befindet.

2. Verfahren zur Herstellung einer Mikrostruktur nach Anspruch 1, wobei die Mikrostruktur außerdem eine Trägerschicht (10) für die erste Schicht (20) umfasst, **dadurch gekennzeichnet, dass**:
- in dem Träger (10) ein Schacht (17) ausgebildet wird, dessen Mündung sich gegenüber dem Abschnitt (B) der inneren Fläche der ersten Schicht (20) befindet; und
- die Verbindung des Drahts (52) mit der inneren Fläche der ersten Schicht (20) durch den Schacht (17) verwirklicht wird.

3. Verfahren zur Herstellung einer Mikrostruktur nach Anspruch 2, **dadurch gekennzeichnet, dass** nach dem Ausbildungsschritt eine räumlich begrenzte Kontaktschicht (53) auf dem Boden des Schachts (17) abgelagert wird, wobei die Verbindung zwischen dem Verbindungsdraht (52) und der ersten Schicht (20) mittels der Kontaktschicht (53) erfolgt.

4. Mechanische Mikrostruktur, die eine erste verformbare Schicht (20) umfasst, die sich auskragend gegenüber einer zweiten Schicht (30) befindet, die einen Hohlraum aufweist, der zurückspringend von einer äußeren Fläche der ersten verformbaren Schicht (20) ausgebildet ist, wobei die erste Schicht (20) einen Abschnitt (B) aufweist, mit dem ein Draht (52) verbunden ist, wobei sich der Abschnitt (B) gegenüber einer Bodenzone des Hohlraums befindet, in den ein Anschlaghöcker (37) vorsteht, **dadurch gekennzeichnet, dass** sich der Anschlaghöcker (37) in einem Abstand von der ersten verformbaren Schicht (20) befindet.

5. Mechanische Mikrostruktur nach Anspruch 4, die außerdem eine Trägerschicht (10) der ersten Schicht (20) aufweist, **dadurch gekennzeichnet, dass** der Träger (10) einen Schacht (17) aufweist, dessen Mündung sich gegenüber dem Abschnitt (B) der inneren Fläche der ersten Schicht (20) befindet.

6. Mikrostruktur nach Anspruch 5, **dadurch gekennzeichnet, dass** sie eine räumlich begrenzte Kontaktschicht (53) am Boden des Schachts (17) aufweist, wobei die Verbindung zwischen dem Verbindungsdraht (52) und der ersten Schicht (20) mittels der Kontaktschicht (53) erfolgt.

7. Mikrostruktur nach einem der Ansprüche 5 oder 6, wobei die Mikrostruktur eine isolierende Schicht (12) zwischen der ersten Schicht (20) und der Trägerschicht (10) aufweist, **dadurch gekennzeichnet, dass** die isolierende Schicht (12) unter den Rändern des Schachts (17) eine Vertiefung (18) aufweist.

## Claims

1. A method of producing a mechanical microstructure including a deformable first layer (20) cantilevered relative to a second layer (30) including a cavity set back from an external face of said deformable first layer (20), in which method a wire (52) is connected to a portion (B) of an internal face of said deformable first layer (20), said portion (B) being opposite a bottom area of said cavity into which an abutment stud (37) projects, **characterized in that** said abutment stud (37) is at a distance from said deformable first layer (20).

2. A microstructure production method according to claim 1, said microstructure further including a support layer (10) for said first layer (20), which method is **characterized in that**:
- a well (17) is formed in said support (10) opening opposite said portion (B) of the internal face of the first layer (20); and
- said wire (52) is connected to said internal face of the first layer (20) via said well (17).

3. A microstructure production method according to claim 2, which method is **characterized in that**, after said step of forming a well, a localized contact layer (53) is deposited on the bottom of said well (17), said connection between the connecting wire (52) and said first layer (20) being made by means of said contact layer (53).

4. A mechanical microstructure including a deformable first layer (20) which is cantilevered relative to a second layer (30) including a cavity set back from an external face of said deformable first layer (20), the first layer (20) including a portion (B) to which is connected a wire (52), said portion (B) being opposite a bottom area of said cavity into which an abutment stud (37) projects, **characterized in that** said abutment stud (37) is at a distance from said deformable first layer (20).

5. A mechanical microstructure according to claim 4, further including a support layer (10) for said first layer (20), **characterized in that** said support (10) includes a well (17) opening opposite said portion (B) of the internal face of said first layer (20).

6. A microstructure according to claim 5, **characterized in that** it includes a localized contact layer (53) at the bottom of said well (17), said connection between the connecting wire (52) and said first layer (20) being made by means of said contact layer (53).

7. A microstructure according to either claim 5 or claim 6, said microstructure including an insulative layer (12) between said first layer (20) and said support layer (10), **characterized in that** said insulative layer (12) includes an undercut (18) under the edges of said well (17).
